# EUROPEAN PATENT SPECIFICATION

(11) **EP 2 015 366 B1**
(45) Date of publication and mention of the grant of the patent: **13.04.2011**
(21) Application number: 07112455.6
(22) Date of filing: 13.07.2007
(51) Int. Cl.: H01L 31/0352, H01L 27/146

(54) **Superlattice structure for photodetection incorporating coupled quantum dots**
Übergitterstruktur zur Photodetektion mit gekoppelten Quantenpunkten
Structure de super-réseau pour la photodétection intégrant des points quantiques couplés

(43) Date of publication of application: 14.01.2009
(73) Proprietor: Acreo AB, 164 40 Kista (SE)
(72) Inventor: Höglund, Linda, 590 41, Rimforsa (SE); Andersson, Jan, 171 42, Solna (SE); Martijn, Henk, 194 64, Upplands Väsby (SE)
(74) Representative: Badel, Xavier Claude Yves

(56) References cited:
- SPRINGHOLZ G: "Three-dimensional stacking of self-assembled quantum dots in multilayer structures" COMPTES RENDUS - PHYSIQUE, ELSEVIER, PARIS, FR, vol. 6, no. 1, January 2005 (2005-01), pages 89-103, XP004738859 ISSN: 1631-0705
- Q. WANG ET AL.: PROCEEDINGS OF SPIE, vol. 6327, 2006, XP002457884 Multilayer InAs/InGaAs quantum dot structure grown by MOVPE for optoelectronic device applications
- LEE H J ET AL: "Structural defects in the growth of multiple periods of InAs quantum dots on a GaAs substrate" JOURNAL OF CRYSTAL GROWTH, ELSEVIER, AMSTERDAM, NL, vol. 172, no. 1-2, February 1997 (1997-02), pages 18-24, XP004110368 ISSN: 0022-0248
- RYUJI OSHIMA ET AL: "Fabrication of Multi-layer Self-assembled InAs Quantum Dots for High-Efficiency Solar Cells" PHOTOVOLTAIC ENERGY CONVERSION, CONFERENCE RECORD OF THE 2006 IEEE 4TH WORLD CONFERENCE ON, IEEE, PI, May 2006 (2006-05), pages 158-161, XP031007262 ISBN: 1-4244-0016-3

## Description

### Technical field

The present invention relates to a solid-state structure for photodetection, a method of manufacturing such a solid-state structure, and use of such solid-state structure for photovoltaic photodetection.

### Technical background

Photodetectors are used in many areas for various purposes, e.g. solar energy conversion, thermal detection, communication, remote temperature detection and military night-vision imaging. There exist a wide range of photodetecting principles and the respective design of the related photodetectors depends on the application and the prioritized parameters to measure.

Photon detectors can be subdivided into photoconductive and photovoltaic devices. The function of photoconductive detectors is based on the photogeneration of charge carriers, i.e. electrons, holes or electron-hole pairs. These charge carriers increase the conductivity of the device material. Detector materials possible to utilize for infrared photoconductive detectors are, for example, indium antimonide (InSb), GaAs/AlGaAs quantum well structures, mercury cadmium telluride (Mercad, MCT), lead sulfide (PbS) and lead selenide (PbSe).

Photovoltaic devices require an internal potential barrier with a built-in electric field in order to separate photo-generated electron-hole pairs. Such potential barriers can be created by the use of p-n junctions or Schottky barriers. Whereas the current-voltage characteristics of photoconductive devices are symmetric with respect to the polarity of the applied voltage, photovoltaic devices exhibit rectifying behaviour. Examples of photovoltaic infrared detector types are based on materials comprising InSb, MCT and platinum silicide (PtSi), i.e. a silicon schottky barrier.

Photon detectors may also be classified on the basis of whether the photo-transitions take place across the fundamental band gap of the infrared sensitive material, or from impurity states to either of the valence or the conduction band. In the first case they are denoted intrinsic, in the latter case extrinsic.

As mentioned above, an established photodetector is based on the Mercury-Cadmium-Telluride (HgCdTe) material system, which has a high responsivity, i.e. the detector gives a perceptible and distinct response to photon radiation. This is due to that the photodetection is based on interband absorption, i.e. the energy of the absorbed photons is equal to or larger than the energy of the band gap. By changing the composition of HgCdTe-system, i.e. the relative proportion of material, and thereby the bandgap, the detector can be tailored for arbitrary cut-off wavelengths. A drawback with this HgCdTe-detector is the difficulties of forming a uniform HgCdTe-material. In particular, compositions tailored for the long wavelength infrared region (LWIR, 8 µm - 12 µm), which require a higher content of mercury are highly sensitive to heat, which makes them difficult to process. This could lead to an enhanced density of defects and a non-uniform material since mercury is highly diffusive. This causes problems when producing large detector arrays, since uniform, defect-free material is then required and as a result, these arrays are expensive to fabricate.

Another established detector type is the quantum well infrared photodetector (QWIP). A quantum well is a semiconducting layer sandwiched between barrier layers, which causes a quantum confinement effect, i.e. a restriction of electrons and holes in one dimension. Furthermore, there exist other quantum confining structures, such as quantum wires with a two-dimensional restriction and quantum dots, which restricts the electrons and holes in three dimensions. The depth of the quantum well can be designed by changing the composition of the semiconducting material and/or barrier material, and the width can be tailored by changing the thickness of such layers. The absorption in a quantum well is due to intersubband absorption, i.e. the absorption energy equals the energy difference between two subbands within the conduction band (or within the valance band), which is not as effective as the interband absorption of the HgCdTe-detector. Thus, the responsivity of the detector is lower and the bandwidth of the detectable wavelength smaller. However, the uniformity of the material of the QWIP is very good, which makes them suitable for producing large detector arrays.

The two above mentioned detector types, along with other types of detectors, usually require cooling to cryogenic temperatures to achieve good detection, or more specifically to suppress dark current. Dark current implies the occurrence of current in the photodevice even in the absence of photons. Dark current have several deleterious effects on the detector performance, one of them being higher noise. Consequently, the presence of dark current has a negative effect on signal to noise ratio and thereby detectivity (D*). Thus, it is preferably that the device is cooled to an operating temperature at which the performance of the photodevice is relatively unaffected by the dark current. The cooling of the detector is a costly and complex process and consequently, great effort has been made to increase the operating temperature. One way of doing this is disclosed in the patent application publication US 2002/0094597 A1, where quantum dots are used. A dot restricts the electrons and holes in three dimensions instead of one dimension, which is the case for wells and the presence of dark current is thereby reduced.

As published in a review article entitled "Three-dimensional stacking of self-assembled quantum dots in multilayer structures", Comptes rendus - physique, Elsevier, Paris, FR, vol. 6, no. 1, of January 2005, by Springholz G., there may be different mechanisms resulting in dot stackings for Si/Ge, InAs/GaAs and PbSe/PbEuTe quantum dot material systems. In particular, three basic mechanisms inducing interlayer correlations are disclosed, namely (i) elastic interactions due to the strain fields of the buried dots, (ii) morphological interactions due to nonplanarized spacer topographies or (iii) interactions based on chemical composition modulations within the spacer material. For example, a PbSe/PbEuTe quantum dot superlattice may be arranged in an ABCABC stacking with 5 ML PbSe alternating with 45 nm PbEuTe, i.e. PbSe quantum dots vertically separated by Pb₁₋ₓEuₓTe spacer layers.

The above mentioned detector types may be categorized as photon detectors and usually require cooling. A thermal detector, however, usually does not require cooling. The operation of thermal detectors depends on a two-step process. The absorption of infrared radiation in these detectors raises the temperature of the device, which in turn changes some temperature-dependent parameter such as electrical conductivity. Thermal detectors may be thermopile (Seebeck effect), resistive or capacitive bolometer, Golay cell detectors, or pyroelectric detectors.
The major advantage of thermal detectors is that they can operate at room temperature. However, the sensitivity is lower and the response time longer than for photon detectors. This makes thermal detectors suitable for the most common focal plane array operations, where the latter two properties are less critical. However, when fast phenomena need to be captured, usually photon detectors are needed.

### Summary of the invention

An object of the invention is to provide an alternative structure for detection of photons, which can be operated at a higher temperature than what is normal. This object is met by the invention as defined in the independent claims. Specific embodiments of the invention are defined in the dependent claims. In addition, the present invention has other advantages and features apparent from the description below.

According to a first aspect of the invention, there is provided a solid-state structure for photodetection of radiation within a wavelength range, said structure being carried by a semiconducting substrate, which substrate is essentially non-absorbent to radiation within said wavelength range. The solid state structure comprises a set of levelled superlattice columns arranged in parallel, where each superlattice column comprises an alternating series of quantum dots, in which each pair of two consecutive quantum dots comprises quantum dots arranged of a first and second semiconducting material, respectively. Said structure further comprises a matrix material arranged in between said set of superlattice columns, the matrix material being a semiconducting material having a lattice-mismatch relative the quantum dots in the columns, which matrix material is essentially non-absorbent to radiation within said wavelength range, and wherein the lattice constant of said matrix material is substantially equal to the lattice constant of said substrate.

Lattice-mismatch is the mismatch between two materials with different lattice constants. Such mismatch normally provides a defect-free expitaxial or crystalline interface between these two materials.

The solid-state structure is arranged for detection of photons within a wavelength range from about 3 µm to about 12 µm, and more preferably in the range from about 3 µm to about 5 µm or about 8 µm to about 12 µm, thus providing a structure for detection in the medium wavelength range (MWIR, 3 µm - 5 µm) or in the LWIR range.

An advantage of the structure of the present invention where superlattice quantum dot columns are used for detection of photons, is that the dots confine the charge carriers in three dimensions, thus making energy levels in the dots discrete. This lowers the amount of dark current, thereby reducing the need for cooling of the photodetecting structure and as a consequence higher operating temperatures are possible. Moreover, the alternating quantum dots are quantum mechanically coupled, enabling formation of a new bandgap between the lowest conduction band energy level of the quantum dot of the first semiconducting material and the highest valence band energy level of the quantum dot of the second semiconducting material, or vice versa, a new bandgap between the lowest conduction band energy level of the quantum dot of the second semiconducting material and the highest valence band energy level of the quantum dot of the first semiconducting material. This new bandgap can be tailored by adjusting the size and composition of the respective quantum dots and hence the cut-off wavelength of the detector can be adjusted to the wavelength region of interest. One further advantage achieved by using coupled quantum dots is that the corresponding electron mass is larger than, for example, the electron effective mass in small band gap materials, such as HgCdTe, which leads to a reduction of the tunnelling contributions to the leakage currents in the structure.

An essentially non-absorbent substrate or matrix material is here defined as a substrate or material with an absorption coefficient less than or equal to 1 cm⁻¹ within said wavelength range.

By definition, a superlattice is a structure of a plurality of layers in a periodic arrangement. The layers are thin enough such that overlap between the electron and hole wave functions of the constituent thin layers takes place. In the solid-state structure according to the present invention, the layers are replaced by a plurality of alternating quantum dots.

The lattice constant of the semiconducting matrix material and the substrate material are substantially equal, such that the matrix material is lattice-matched to the substrate. Substantially equal is here defined as less than or equal to 0.2 % difference in lattice constant between the substrate and the matrix material. This lattice-matching of the substrate and the matrix material ensures the quality of the solid-state structure regarding the average uniformity of the material, e.g. by reducing the amount of dislocations in the solid-state structure. Thus, this enables the fabrication of large detector arrays.

In an embodiment of the present invention, the solid-state structure has, up to an operating temperature of about 150 K in the MWIR range and about 100 K in the LWIR range, a ratio between photocurrent and dark current of at least 10, assuming that the detector is operated in the reversed bias current mode with the camera optics characteristics: f-number equal to 1 and optical transmission of lenses equal to 100 %. Thus, a higher operating temperature than what is normal is provided.

In a further embodiment of the present invention, the solid-state structure is a monocrystalline arrangement. A monocrystalline or single crystalline structure is a structure where all atoms therein are related to one and the same regular, three-dimensional arrangement of atomic lattice points. This avoids the formation of dislocations or crystal boundaries within the structure, thereby decreasing the amount of leakage currents that originate from dislocations and other defects. A dislocation is a discontinuity in the otherwise ordered crystal lattice of a crystalline material. Consequently, the monocrystalline photodetecting structure according to the present invention normally ensures low noise levels during detection.

In yet a further embodiment of the present invention, the matrix material and the substrate material could also be of the same material. The same material of the substrate and the matrix material increase the quality of the solid-state structure regarding the uniformity of the material even further, e.g. reducing the amount of dislocations. Thus, this facilitates the fabrication of large high-performance detector arrays.

In an additional embodiment of the present invention, the superlattice columns of the solid-state structure exploit self-organized quantum dots, which are usually fabricated epitaxially using the so called Stranski-Krastanow growth mode. The formation is due to a lattice-mismatch between the matrix material and the deposited material, the latter acting as a material source for the quantum dots. In order for quantum dots to form, the lattice-mismatch between the matrix material and the deposited material should be in the interval of about 2 % to about 10 %. This lattice-mismatch is large enough for the formation of quantum dots, but sufficiently low such that mismatched materials still form a monocrystalline structure.

The QDs are preferably formed onto the matrix material at positions where the strain energy is low. Strain energy is the energy which is incorporated into a resulting structure when two crystalline materials of originally different lattice constants are joined together. This enables self-alignment of the quantum dots into columns, since it is energetically more favourable for the dot to grow directly above an already existing quantum dot. Alignment of the quantum dots increases the quantum mechanical coupling between adjacent quantum dots, which in turn creates a proper miniband structure which is essential for a proper detector function, such as wavelength response. In addition, it also enhances the charge carrier transport to the contact layers. Consequently, self-aligned quantum dots here imply a quantum dot which automatically becomes aligned over a previously grown quantum dot.

In a further embodiment of the present invention, the quantum dots in at least one superlattice column are separated by a domain of matrix material. The quantum dots in the columns sometimes differ in height, which could result in unlevelled columns due to this height variation. In other words, it is sometimes necessary to fill up the space between the layer of quantum dots to planarize or level the surface, giving the next layer or set of quantum dots good growth conditions. Preferably, embedding the consecutively arranged quantum dots by matrix material ensure a levelled set of QD columns.

In yet a further embodiment of the present invention, first and second semiconducting materials, respectively, exhibit a type II energy level alignment with respect to each other, such that electrons are confined in the quantum dots of the first semiconductor material and holes are confined in the quantum dots of the second semiconductor material. The purpose is to separately confine the electrons and holes in different quantum dots, i.e. one type of quantum dots confines electrons and the other type of quantum dots confines holes. This enables interband absorption in the MWIR or LWIR range, with high responsivity and a wide bandwidth, provided that the various structure parameters are carefully selected.

In another embodiment of the present invention, the first and second semiconducting material each comprises a III-V material, i.e. a compound material consisting of elements chosen from group III and group V material of the periodic system. Alternatively, the first and second semiconducting material are each selected from the group IV materials, or a combination of III-V materials and group IV materials. Preferably, the first semiconducting material comprises an indium compound, and more preferably indium arsenide, i.e. InAs. In an arbitrary combination with the alternatives of the first semiconducting material mentioned above, the second semiconducting material comprises an antimonide compound, and more preferably gallium indium antimonide, or GaₓIn₁₋ₓSb. In an arbitrary combination with the alternatives of the first and second semiconducting materials, the matrix material comprises a material selected from either the III-V or group IV materials, and preferably GaAs, InP or Si.

In another embodiment of the present invention, the solid-state structure comprises a first highly p-doped region, a second undoped region and a third highly n-doped region in a direction parallel with the columns, wherein the second region is arranged in between the first and the third regions. The second undoped region may be an intrinsic, i.e. low doped, region. Alternatively, the matrix material of the first and third region is doped. Instead of doping the matrix material, the quantum dots in the regions may be doped. Thus, in another alternative, the quantum dots of the first semiconducting material in the first region are doped and the quantum dots of the second semiconducting material in the third region are doped. Furthermore, both the matrix material and the quantum dots of the regions may be doped. In a further embodiment of the present invention, the quantum dots of the first semiconducting material in the first region are doped and the quantum dots of the second semiconducting material in the third region are doped. In combination with the above mentioned alternatives, the second region comprises doped matrix material and/or doped quantum dots of the first or second semiconducting material. The matrix material and/or the quantum dots of the first or second semiconducting material in the second region may be low p- or n-doped, or alternatively highly p- or n-doped. Furthermore, the second region may be doped intentionally or unintentionally.

Preferably, the quantum dots comprising gallium, indium and antimonide in the first and second doping region are p-doped, and the quantum dots comprising indium and arsenide in the third doping region are n-doped. In an alternative embodiment of the invention, the matrix material and the quantum dots of first semiconducting material in the first and second region are doped, and matrix material and the quantum dots of the second semiconducting material in the third region is doped.

In yet a further embodiment of the present invention, an assembly is provided, comprising a solid-state structure according to the present invention and a first and a second contact layer arranged at either side of such a structure, and a semiconducting substrate arranged outside one of the contact layers. In other words, the solid-state structure is sandwiched between the contact layers. Furthermore, the structure and one of the contact layers are sandwiched between the substrate and the other contact layer, resulting in a photodetector structure. Preferably, the contact layers comprise highly doped semiconducting material.

In addition, the solid-state structure of the present invention may be arranged as a pixel element, which, when associated to a plurality of substantially similar pixel elements, forms a pixellated detector array. Such pixellated detector arrays can then be employed in an infrared camera.

According to a second aspect of the invention, there is provided a method of manufacturing a solid state structure for photodetection of radiation within a wavelength range comprising the steps of providing a semiconducting substrate, said substrate being non-absorbent to radiation within said wavelength range, forming in a self-organizing manner a first set of quantum dots of a first semiconducting material on the substrate, forming a semiconducting matrix layer in between the quantum dots of the first set, such that the semiconducting matrix layer covers at least a lateral surface of the quantum dots, forming in a self-organizing manner a second set of quantum dots of a second semiconducting material such that the first set is arranged between said substrate and said second set, and such that a set of columns of aligned quantum dots is formed, forming a semiconducting matrix layer in between the quantum dots of the second set, covering at least a lateral surface of the quantum dots, repeating the formation of the first and second set of quantum dots and the covering matrix layers, such that a set of quantum dot superlattice columns in a matrix material is formed, and wherein said steps of forming a semiconducting matrix layer includes forming a semiconducting matrix layer of a material having a lattice constant essentially equal to that of the substrate, and wherein said semiconducting matrix layer is essentially non-absorbent to radiation within said wavelength range.

An advantage of the method of manufacturing a solid-state structure of the present invention, is that it provides a uniform material suitable for the fabrication of large detector arrays. Furthermore, the self-organizing quantum dots of the method according to the present invention, results in a material with a lower degree of dislocations, which, as explained above, reduces the dark current and consequently enables higher operating temperatures. Additionally, the method according to the present invention enables the use of a wide range of materials since less consideration has to be taken regarding lattice-mismatch, i.e. the material of the quantum dots can be chosen more freely with respect to the surrounding material, thus enabling a great freedom in design. For example, the photodetecting solid-state structure can be grown on a 4" GaAs-substrate instead of 3" GaSb-substrate, which results in a larger, more uniform and easily workable material. Additionally, a GaAs-substrate provides a more reliable manufacturing process, because making the GaSb-substrate thinner, since it otherwise would absorb a non-negligible amount of IR-radiation, is very difficult and complex. As is understood, any other substrate material, which is suitable for photodetection, may be used.

In an embodiment of the method of manufacturing a solid-state structure of the present invention, the steps of forming the semiconducting matrix layer and the first and second set of quantum dots includes epitaxial forming of a semiconducting matrix layer and a first and second set of quantum dots. The advantageous epitaxial formation results in a monocrystalline structure and such a structure avoids dislocations or crystal boundaries, thereby decreasing the amount of leakage currents and ensuring low noise levels during detection.

In an embodiment of the method of manufacturing a solid-state structure of the present invention, the step of forming the semiconducting matrix layer includes forming a semiconducting matrix layer of the same material as the substrate. By forming a semiconducting matrix layer of the same material as the substrate, a crystal boundary is avoided in the interface between the substrate and the semiconducting matrix layer. Thus, the uniformity of the resulting structure is enhanced even further, facilitating the fabrication of large detector arrays.

In a further embodiment of the method of manufacturing a solid-state structure of the present invention, the step of forming the first and second set of quantum dots includes forming a first and second set of quantum dots of a III-V material. Alternatively, the step of forming the first set of quantum dots includes forming a first set of quantum dots of an indium compound material, and preferably a material comprising indium and arsenide. In an arbitrary combination with the alternatives of forming the first set of quantum dots, the step of forming the second set of quantum dots includes forming a second set of quantum dots of an antimonide compound material, preferably a material comprising gallium, indium and antimonide. In an arbitrary combination with the alternatives above, the step of forming the semiconducting matrix layer includes forming a semiconducting matrix layer of a III-V material, preferably GaAs or InP, or includes forming a semiconducting matrix layer of a IV material, preferably Si.

In a further embodiment of the method of manufacturing a solid-state structure of the present invention, the step of forming the set of quantum dot superlattice columns in a matrix material includes forming a first highly p-doped region on the substrate, and forming a second low p-doped region on the first region, and forming a third highly n-doped region on the second region.

In yet another embodiment of the method of manufacturing a solid-state structure of the present invention, the step of forming a first highly p-doped region on the substrate includes forming a first doped region of highly p-doped matrix layers, and wherein the step of forming a third highly n-doped region on the second region includes forming a third doped region of highly n-doped matrix layers.

In an alternative embodiment, instead of forming doped matrix layers, in the doped regions the quantum dots and/or the matrix material are doped. Thus, the step of forming a first highly p-doped region and/or highly p-doped matrix material on the substrate includes forming a first doped region of a second set of highly p-doped quantum dots of a first semiconducting material, and the step of forming a third highly n-doped and/or highly n-doped region on top of the second region includes forming a third doped region of a second set of highly n-doped quantum dots of a first semiconducting material.

In an alternative embodiment of the method of the present invention, the step of forming a second doped or undoped region includes forming a second doped region of a first set of low n- or p-doped quantum dots of a first or second semiconducting material, respectively, and/or a low nor p-doped matrix layers.

Instead of forming a pnp-doped structure, a npn-doped may be formed. Thus, the method of the present invention may include forming of a first highly n-doped region on the substrate, forming a second doped or undoped region on the first region, and forming a third highly p-doped region on the second region. Furthermore, the step of forming a third highly p-doped region on the second region include forming a third doped region of highly p-doped matrix layers, or alternatively, the step of forming a third highly p-doped region on the second region includes forming a third doped region of a second set of highly p-doped quantum dots of a second semiconducting material. In an alternative, the step of forming a second doped or undoped region include forming a second doped region of a first set of low n- or p-doped quantum dots of a first or second semiconducting material, respectively, and/or a low n- or p-doped matrix layers.

In an embodiment of the method of manufacturing a solid-state structure of the present invention, the step of forming the semiconducting matrix layer includes using molecular beam epitaxy (MBE) to deposit a semiconducting matrix layer. Alternatively, forming of the matrix material can be done by using metal-organic vapour-phase epitaxy (MOVPE). Furthermore, various combinations of MBE and MOVPE can also be used to deposit a semiconducting matrix layer, e.g. chemical beam epitaxy (CBE) or MOMBE (metal organic molecular beam epitaxy). In a further embodiment, the step of forming the first and second set of quantum dots of the first and second semiconducting material, includes using an electrochemical process to deposit a set of quantum dots.

In an embodiment of the method of manufacturing a solid-state structure of the present invention, the method further comprises the steps of providing a first contact layer on the substrate prior to the step of forming the first set of quantum dots on the substrate, and providing a second contact layer over the set of quantum dot superlattice columns in the matrix material. Thus, the forming of contact layers enables the solid-state structure to be electrically connected, which enables the structure to function as a photodetector.

According to a third aspect of the invention, a solid-state structure is used for photovoltaic photodetection of radiation within a wavelength range of about 3 µm to about 12 µm, wherein the structure comprises an alternating series of quantum dots, in which each pair of two consecutive quantum dots comprises quantum dots, arranged of a first and second semiconducting material, respectively, and the first and second semiconducting material are each selected from the III-V materials.

The use of such a solid-state structure provides efficient structures which can be used at higher operating temperatures for detecting infrared radiation.

In an embodiment of using the solid-state structure of the present invention, the alternating series of quantum dots are combined with an embedding matrix material, for providing a monocrystalline solid-state structure.

Generally, all terms used in the claims are to be interpreted according to their ordinary meaning in the technical field, unless explicitly defined otherwise herein. All references to "a/an/the [element, device, component, means, step, etc]" are to be interpreted openly as referring to at least one instance of said element, device, component, means, step, etc., unless explicitly stated otherwise. Other objectives, features and advantages of the present invention will appear from the following detailed disclosure, from the attached dependent claims as well as from the drawings.

### Brief description of the drawings

The above, as well as additional objects, features and advantages of the present invention, will be better understood through the following illustrative and non-limiting detailed description of preferred embodiments of the present invention, with reference to the appended drawings, wherein the same reference numerals are used for similar elements, and in which:
Fig. 1a is a schematic view of a solid-state structure for photodetection in accordance with an embodiment of the present invention.
Fig. 1b is a schematic view of a solid-state structure for photodetection in accordance with another embodiment of the present invention.
Fig. 2a, 2a', 2b, 2c, 2c', 2d and 2e are schematic illustrations of different band gap configurations for trapping charge carriers in a semiconducting material.
Fig. 2f is a schematic illustration of a band gap configuration in accordance with the present invention.
Fig. 3a is a schematic view of a doped solid-state structure for photodetection in accordance with an embodiment of the present invention.
Fig. 3b is a schematic view of a doped solid-state structure for photodetection in accordance with another embodiment of the present invention.
Fig. 4 is a schematic view of a photodetector with a solid-state structure in accordance with another embodiment of the present invention.
Fig. 5 is a schematic view of a photodetector with a solid-state structure, which schematically shows a layered solid-state structure in accordance with an embodiment of the present invention.

### Detailed description of embodiments of the invention

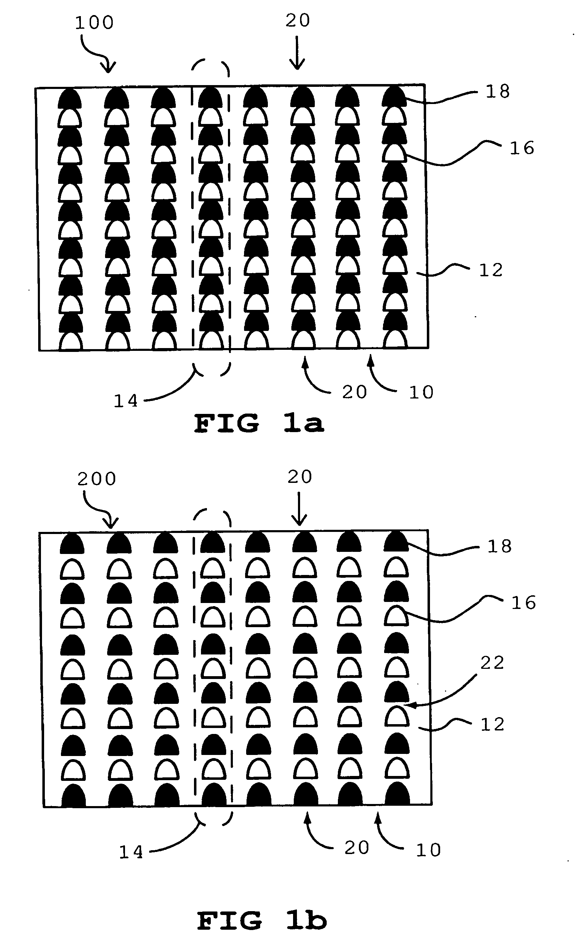

With reference to Fig. 1a, a first embodiment of the present invention will be described. Fig. 1a schematically illustrates a side view of a solid state structure 100 comprising a set of levelled columns or pillars 14, which are embedded in a matrix material 12. These vertically extending columns or pillars 14 include quantum dots 16 of a first semiconducting material and quantum dots 18 of a second semiconducting material. Quantum dots 16 and 18 are hereinafter also referred to QD16 and QD18, respectively. The columns are normally levelled such that they at the distal ends of the columns form two common planes, respectively. Quantum dots 16 and 18 are arranged in a relative position or order such that an arrangement of QD16 and QD18 forms a superlattice column or pillar 14. As can be seen in Fig. 1a, quantum dots 16 and 18 are positioned in an alternating arrangement on top of each other in columns or pillars 14 such that a QD16 has a QD18 at either side, in the vertical direction, and obviously the vice verse, a QD18 has a QD16 at either side. Although, it is understood that the quantum dots at the ends 20 of the column or pillar 14 only have a neighbouring quantum dot at one side.

Fig. 1b shows a solid-state structure 200 in accordance with the invention. Compared with the structure 100 in Fig. 1a, the quantum dots 16 and 18 in each column or pillar 14 in Fig. 1b are separated by a matrix material 12, i.e. there is a space or portion 22 of matrix material 12 between two consecutively positioned quantum dots 16 and 18 in the column or pillar 14. The height of the separation 22 may vary throughout the solid-state structure 200 due to varying height of the quantum dots 16 or 18. However, the separation 22 is sufficiently small such that two consecutively positioned or arranged quantum dots 16 and 18 in the column or pillar 14 could be quantum mechanically coupled and hence electrically coupled to each other.

The quantum dots 16 and 18, as shown in Fig. 1b, have varying height and thickness, which, for example, is due to the selected materials and/or the manufacturing process. The longest dimension defining the size of the quantum dots 16 and 18 is comprised in the range of 1 to 500 nm, and preferentially in the range of 10 to 50 nm. Since the quantum dots 16 and 18 are self-organized, the columns 14 are positioned where the first set of self-organized quantum dots 16 and 18 arranged themselves during the manufacturing process. Because of this self-organizing property of the quantum dots, the superlattice columns are self-aligned. The self-aligned columns 14 are thus separated from each other by distance, which varies throughout the structure. In Fig 1a and Fig. 1b, the columns 14 appears to be equally distanced from each other, but it is understood that this is only for schematically illustrative reasons. Accordingly, the distance between the columns 14 may vary in the range of about 2 to about 10 nm.

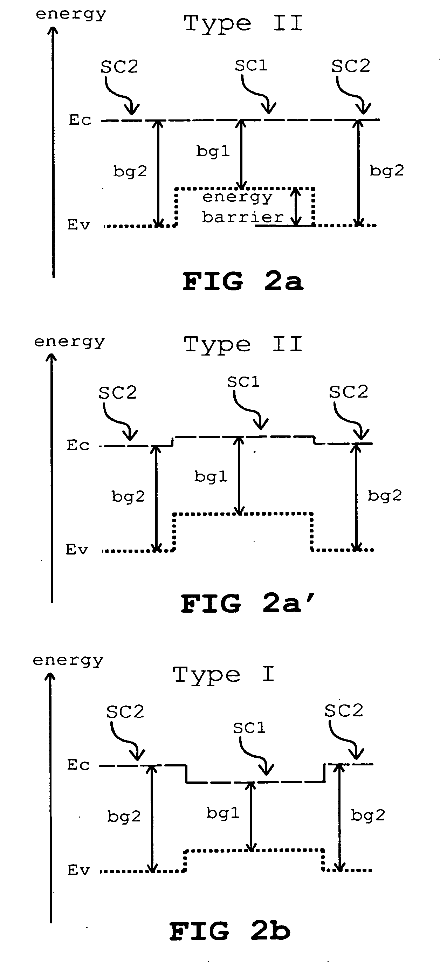

Referring now to Fig. 2a to Fig. 2e, which explains the different type of heterostructures. The illustrations are based on a layer which is provided with quantum dots QD, corresponding to quantum dots 16 or 18, made of a first semiconductor material SC1, which is surrounded by a second semi-conductor material SC2, corresponding to the matrix material, acting as a barrier material BM. The barrier material BM is selected such that charge carriers are trapped within the quantum dots QD under steady-state conditions.

The trapping of the charge carriers in the quantum dots QD can be achieved when the band gaps of the first and the second semiconductor materials SC1 and SC2 are arranged to create an energy barrier for trapping the charge carriers localized within the quantum dots in either (or both) the valence band or the conduction band. Starting with two semiconductor materials SC1 and SC2 having two different band gaps bg1 and bg2, seven typical band gap configurations providing charge trapping in the first semiconductor material SC1 are schematically illustrated in Fig. 2a to Fig. 2e. These configurations illustrate three typical groups of heterostructures commonly defined as type I where both electrons and holes are trapped inside the quantum dots QD made of the first semiconductor material SC1, for example InAs quantum dots embedded in GaAs; type II where only charge carriers of one type are trapped inside the quantum dots QD made of the first semiconductor material SC1 (i.e. either electrons or holes), e.g. Ge quantum dots embedded in Si; and type III where the junction of the first and second semiconductor materials SC1 and SC2 forms a so-called broken gap (see explanation below), e.g. InAs quantum dots embedded in GaSb.

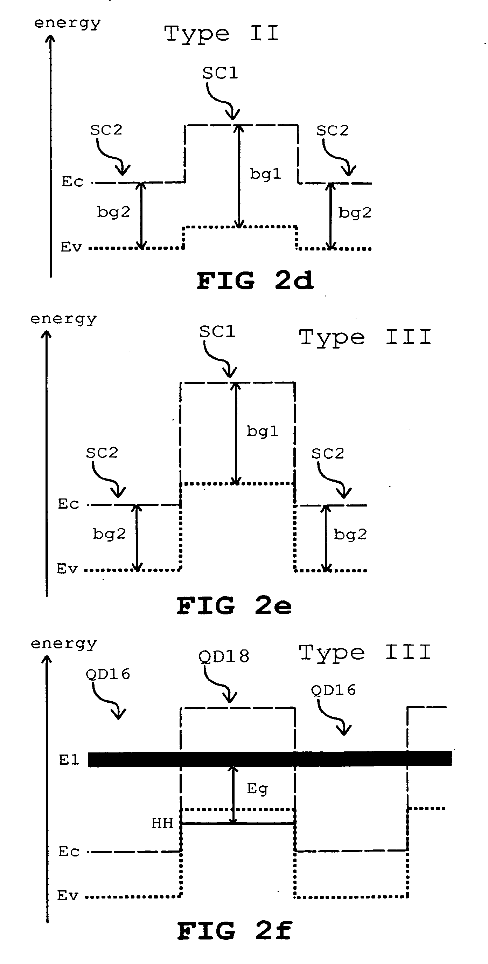

In Fig. 2a to Fig. 2c', the band gap bg1 of the first semiconductor SC1 is smaller than the band gap bg2 of the second semiconductor SC2, while the band gap bg1 of the first semiconductor SC1 is larger than the band gap bg2 of the second semiconductor SC2 in Fig. 2d and Fig. 2e. The conduction bands are represented by dashed lines while the valence bands are represented by dotted lines. In a first configuration (Fig. 2a), the energy band diagrams of the two semiconductors SC1 and SC2 are matched in such a manner that the conduction bands of the two semiconductors are aligned, thus creating an energy barrier in the valence band of the first semiconductor material SC1, which can then trap charge carriers (here holes are trapped in SC1). Note that this configuration (Fig. 2a) is only given as an illustrative example since, in practice, it is not so common that the conduction band of the first semiconductor material SC1 and the conduction band of the second semiconductor material SC2 have exactly the same energy level. Therefore, more commonly another energy barrier smaller than the energy barrier created in the valence band is also present in the conduction band (see Fig. 2a'). This later configuration corresponds to heterostructures of type II.

In a second configuration (Fig. 2b), the energy band diagram of the first semiconductor material SC1 is shifted downwards along the energy axis compared to the configuration shown in Fig. 2a, thus creating an energy barrier both in the conduction band (for electrons) and in the valence band (for holes). Thus, charge carriers (both electrons and holes) are trapped in the first semiconductor SC1. This configuration (Fig. 2b) corresponds to heterostructures of type I.

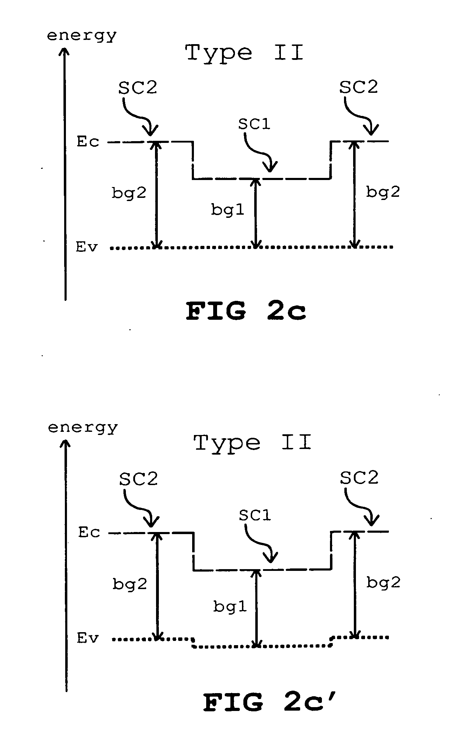

In a third configuration (Fig. 2c), the energy band diagram of the first semiconductor SC1 is even more shifted downwards along the energy axis compared to the configurations shown in Fig. 2a and Fig. 2b so that the valence bands of the first and second semiconductor materials SC1 and SC2 are aligned. In this configuration (Fig. 2c), an energy barrier for electrons is created in the conduction band, thus trapping charge carriers in the first semiconductor SC1. Note that this configuration (Fig. 2c) is only given as an illustrative example since, in practice, it is not so common that the valence band of the first semiconductor material SC1 and the valence band of the second semiconductor material SC2 have exactly the same energy level. Therefore, more commonly another energy barrier smaller than the energy barrier created in the conduction band is also present in the valence band (see Fig. 2c'). This later configuration corresponds to heterostructures of type II. In these five first cases (Fig. 2a to Fig. 2c'), the quantum dots are made of the first semiconductor material SC1 and the barrier material is made of the second semiconductor material SC2, the band gap bg1 of the first semiconductor material SC1 being smaller than the band gap bg2 of the second semiconductor material SC2. As a result, charge carriers are trapped in the quantum dots.

However, other configurations, where the band gap bg1 of the first semiconductor material SC1 can be larger than the band gap bg2 of the second semiconductor material SC2, are possible, as illustrated in Fig. 2d and Fig. 2e. In Fig. 2d, the energy band diagram of the second semiconductor material SC2 is shifted so far downwards along the energy axis compared to the band diagram of the first semiconductor material SC1 that an energy barrier for the holes localized within the first semiconductor material SC1 is created in the valence band. This configuration corresponds to heterostructures of type II, where one type of carriers (here holes) are trapped in the quantum dots made of the first semiconductor material SC1. Thus, the second semiconductor material SC2 having a smaller band gap than the first semiconductor material SC1 acts as a barrier material BM in this case. Similarly, note that in Fig. 2d an energy barrier is created for the electrons localized in the second semiconductor material SC2. Thus, in this configuration (Fig. 2d), depending on whether the operation principle is based on electrons or holes, SC2 could be used as quantum dots material or barrier material, respectively. It will also be appreciated by a person skilled in the art that a similar configuration as that described in Fig. 2d could be obtained if the energy band diagram of the semiconductor material having the smallest band gap was shifted so far upwards along the energy axis that an energy barrier would be created in the conduction band for the charge carriers (electrons) localized within the semiconductor material having the largest band gap SC1 (this configuration is not shown). In these last cases (configuration shown in Fig. 2d and similar ones), the semiconductor material having the smallest band gap can be used as the barrier material BM while the semiconductor material having the largest band gap can be used for the quantum dots QD, which is the opposite to what was described in configurations depicted in Fig. 2a to Fig. 2c'.

In Fig. 2e, the junction of the first and second semiconductor materials SC1 and SC2 forms a so-called broken gap. In this case, the two band gaps bg1 and bg2 are not overlapping, i.e. that the valence band of one material is higher than the conduction band of the other material. As represented in Fig. 2e, the valence band of the first semiconductor material SC1 is at a higher energy level than the conduction band of the second semiconductor material SC2. In this case, charge carriers of one type, here holes, are trapped in the first semiconductor material SC1 while charge carriers of the other type, here electrons, are trapped in the second semiconductor material SC2. This configuration corresponds to heterostructures of type III.

Some of these configurations (in particular the configurations shown in Fig. 2d, Fig. 2e and similar ones) can even be obtained when using semiconductors having substantially equal band gaps (bg1 ≈ bg2). These different configurations, i.e. the relative positions of the band energy diagrams of the first and second semiconductors SC1 and SC2, depend on which semiconductor materials are combined.

Referring now to Fig. 2f, which schematically shows the band gap configuration according to the present invention. The illustration shows three quantum dots, i.e. a section of the superlattice quantum dot column. A quantum dot QD18 which is sandwiched between two quantum dots QD16. As above, Ec and Ev represent the conduction band and valence band, respectively. In Fig. 2f quantum dot QD16 is made of InAs and QD18 of GaInSb, though the quantum dots may be of another semiconducting material. Thus, Fig. 2f represents an energy band configuration of a GaInSb/InAs quantum dot superlattice column according to the present invention. In this case the energy band alignment is of type III, as defined in the previous section, with the InAs conduction band edge at a lower energy than the GaInSb valence band edge. However, due to the confinement of electrons and holes inside the quantum dots, the lowest electron energy levels in the InAs quantum dot are situated at a higher energy than the valence band edge of the GaInSb quantum dots. Thereby the energy level alignment is of type II, with the electrons confined in the InAs quantum dots and the holes confined in the GaInSb quantum dots. The bandgap Eg of the QD superlattice is the energy difference between a first heavy hole state HH and an electron miniband E1.

The materials of the solid-state structure of the present invention can be selected from a wide range of alternatives. Firstly, the first and second semiconducting material of the quantum dots are each selected from the III-V materials, respectively. Preferably, the first semiconducting material comprises an indium compound, and more preferably indium arsenide. The second semiconducting material comprises an antimonide compound, and more preferably gallium indium antimonide. Obviously, it is understood that the first and second semiconducting material can be selected independently of each other as long as a type II energy level alignment is achieved. The matrix material is a semiconducting material selected from the III-V materials, preferably GaAs, and more preferably the same as the substrate material.

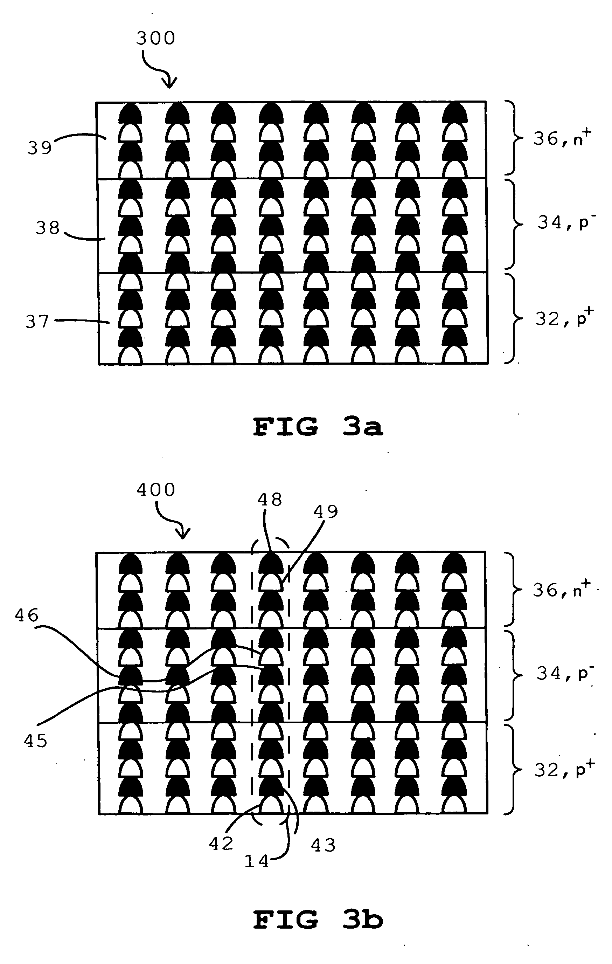

Fig. 3a is a schematic view of a doped solid-state structure for photodetection in accordance with an embodiment of the present invention. The solid-state structure 300 comprises a first highly p-doped (p⁺) region 32, a second low p-doped or (p⁻) region 34 and a third highly n-doped or (n⁺) region 36. The p-doped region 34 could either by doped intentionally or unintentionally. Fig. 3a further illustrates that the matrix material of the first 37, second 38 and third region 39 is doped, compared with Fig. 3b where the quantum dots are doped instead. In other words, the quantum dots of the structure 300 in Fig. 3a are undoped. According to another alternative embodiment, the second region 34 can also be low n-doped or furthermore, the region 34 can also be an intrinsic region.

Fig. 3b is a schematic view of a doped solid-state structure for photodetection in accordance with another embodiment of the present invention. As mentioned above the quantum dots in the columns 14 in structure 400 are here doped, instead of the matrix material as in Fig. 3a. The quantum dots 42 of the first semiconducting material in the first region 32, i.e. p⁺ region, are undoped, whereas the quantum dots of the second semiconducting material 43 is doped. More specifically and not shown in Fig. 3b, quantum dots of the first semiconducting material is preferably a QD of InAs (indium arsenide), and quantum dots of the second semiconducting material is a QD of GainSb (gallium indium antimonide). Thus, the InAs-QD 42 in the first p⁺ region 32 are undoped and the Gaₓln₁₋ₓSb-QD 43 are p⁺-doped. Similarly, the InAs-QD 46 in the second p⁻ region 34 are undoped, whereas the GaInSb-QD 45 are low p-doped. However, in the third highly n⁺-doped region 36 it is the other way around. The InAs-QD 49 in the third n⁺ region 36 are highly n-doped and the GaInSb-QD 48 are left undoped.

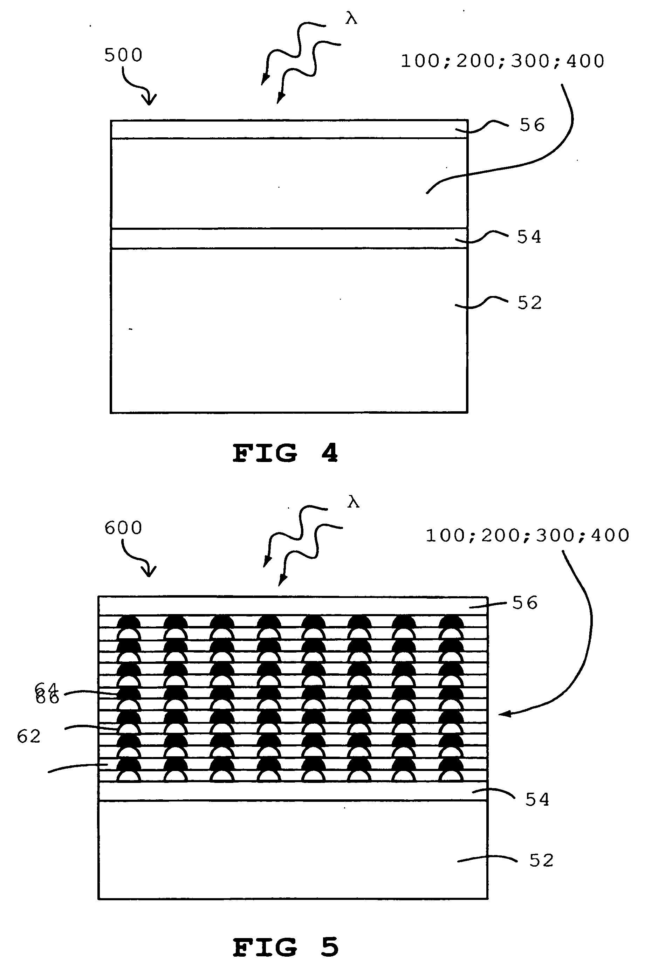

Fig. 4 is a schematic side view of a photodetector with a solid-state structure in accordance with another embodiment of the present invention. The solid state structure 100, 200, 300 or 400 for photodetection of a wavelength range carried by a semiconducting substrate 52, is sandwiched between a first contact layer 54 and a second contact layer 56. The substrate 52 is essentially non-absorbent to photons within said wavelength range, i.e. the amount of photons which is absorbed by the substrate is essentially negligible. The embodiment illustrated in Fig. 4 shows for example an infrared detector 500, incorporating a solid-state structure 100, 200, 300 or 400 according to the present invention, when infrared radiation is incident (depicted with wave-shaped arrows) on the structure, electron-hole pairs are generated in the solid-state structure by excitation of electrons from the valence band to the conduction band. The number of generated electron-hole pairs is proportional to the intensity of the incident radiation. Basically, the detector is based on a p-n junction, which separates the generated electron-hole pairs. The resulting electric field, i.e. accumulation of charge carriers, is then detected. It is understood that the solid state structure 100, 200, 300 and 400 may be arranged in any suitable way between the contact layers. Thus, the doped regions may be ordered according to Fig. 3a or Fig. 3b, but may also be arranged in an inverted manner, i.e. the highly n-doped region at the bottom and the highly p-doped region at the top, arranged to face incident photons. In Fig. 4 and 5, the radiation is incident from above, but it is understood that the radiation may be incident on the substrate side. Though, in such cases, the substrate normally needs further processing, for example etching the substrate to a suitable thickness.

Fig. 5 is a schematic view of a photodetector with a solid-state structure, which schematically shows a layered solid-state structure in accordance with an embodiment of the present invention. Fig. 5 illustrates a photodetector according to an embodiment of the present invention, including a structure 100, 200, 300 and 400, which comprises a set of levelled superlattice columns arranged in parallel and a plurality of matrix layers 62. Each superlattice column comprises an alternating series of quantum dots 64 and 66, in which each pair of two consecutive quantum dots comprises quantum dots, arranged of a first and second semiconducting material, respectively. The quantum dots 64 and 66 are embedded in a plurality of matrix layers 62. Thus, matrix material is arranged between the columns and alternatively also between the constituent quantum dots of the columns (not shown). The matrix material, preferably a semiconducting material, has a lattice-mismatch relative the quantum dots in the columns. Furthermore, the lattice constant of the matrix material is substantially equal to the lattice constant of the substrate.

The realization of such a structure 100, 200, 300 or 400 is possible using common techniques of the semiconductor industry. The quantum dots QD may be produced using epitaxial growth, such as MOVPE, MOCVD, MBE, CBE, MOMBE, or various combinations thereof. Furthermore, the quantum dots may also be produced by electrochemical deposition. These techniques enable the production of single crystalline quantum dots QD. Using epitaxial growth, the material grows atom layer after atom layer normally without any defects such as dislocations, and the quantum dots QD are self-organized at the surface of the substrate. The shape of the quantum dots QD resulting from this self assembly method is normally either lens shaped or of pyramidal shape. However, the quantum dots QD can also be formed by some other methods, for example by pre-patterning a deposited thin film with electron beam lithography or nano-imprint lithography followed by etching techniques, and any shape could be possible, e.g. quadratic, cylindrical, rectangular.

The invention has mainly been described above with reference to a few embodiments. However, as is readily appreciated by a person skilled in the art, other embodiments than the ones disclosed above are equally possible within the scope of the invention, as defined by the appended patent claims.

## Claims

1. A solid-state structure (100, 200) for photodetection of radiation within a wavelength range, said structure being carried by a semiconducting substrate (52), which substrate is essentially non-absorbent to radiation within said wavelength range, comprising
a set of levelled superlattice columns (14) arranged in parallel, where each superlattice column comprises an alternating series of quantum dots (16, 18), and
a matrix material (12) arranged in between said set of superlattice columns, the matrix material being a semiconducting material having a lattice-mismatch relative the quantum dots in the columns, which matrix material is essentially non-absorbent to radiation within said wavelength range, and
wherein the lattice constant of said matrix material is substantially equal to the lattice constant of said substrate,
**characterized in that**, in a superlattice column, each pair of two consecutive quantum dots comprises a quantum dot (16) of a first semiconducting material (SC1) and a quantum dot (18) of a second, different, semiconducting material (SC2) which are quantum mechanically coupled.

2. The structure according to claim 1, wherein the wavelength range is from about 3 µm to about 12 µm.

3. The structure according to claim 2, wherein the wavelength range is from about 3 µm to about 5 µm.

4. The structure according to claim 3, wherein, up to an operating temperature of about 150 K, a ratio between photocurrent and dark current of the solid-state structure is at least 10.

5. The structure according to claim 2, wherein the wavelength range is from about 8 µm to about 12 µm.

6. The structure according to claim 5, wherein, up to an operating temperature of about 100 K, a ratio between photocurrent and dark current of the solid-state structure is at least 10.

7. The structure according to any one of the preceding claims, wherein the solid-state structure is monocrystalline.

8. The structure according to any one of the preceding claims, wherein the matrix material is of the same material as the substrate.

9. The structure according to any one of the preceding claims, wherein the quantum dots in the superlattice columns of the set are organized in a self-aligned manner.

10. The structure according to any one of the preceding claims, wherein the quantum dots in at least one superlattice column are separated by a portion (22) of matrix material.

11. The structure according to any one of the preceding claims, wherein said first and said second semiconducting materials, respectively, exhibit a type II energy level alignment with respect to each other, such that electrons are confined in the quantum dots of the first semiconductor material and holes are confined in the quantum dots of the second semiconductor material.

12. The structure according to anyone of the preceding claims, wherein the first and second semiconducting material are each selected from the III-V materials.

13. The structure according to any one of the preceding claims, wherein the first semiconducting material comprises an indium compound.

14. The structure according to any one of the preceding claims, wherein the first semiconducting material comprises indium and arsenide.

15. The structure according to any one of the preceding claims, wherein the second semiconducting material comprises an antimonide compound.

16. The structure according to any one of the preceding claims, wherein the second semiconducting material comprises gallium, indium and antimonide.

17. The structure according to any one of the preceding claims, wherein the matrix material is selected from the III-V materials.

18. The structure according to claim 17, wherein the matrix material comprises GaAs.

19. The structure according to claim 17, wherein the matrix material comprises InP.

20. The structure according to any one of the claims 1 to 16, wherein the matrix material is selected from IV materials.

21. The structure according to claim 20, wherein the matrix material comprises Si.

22. The structure according to any one of the preceding claims, wherein the structure (300) comprises a first p-doped region (32), a second undoped region (34) and a third n-doped region (36) in a direction parallel with the columns, wherein the second region is arranged in between the first and the third regions.

23. The structure according to claim 22, wherein the matrix material (37, 39) of the first, and third region is doped.

24. The structure according to claims 22 or 23, wherein the quantum dots of the first semiconducting material in the first region are doped and the quantum dots of the second semiconducting material in the third region are doped.

25. The structure (300, 400) according to any one of the claims 22 to 24, wherein the second region (34) comprises doped matrix material (38) and/or doped quantum dots (45, 46) of the first or second semiconducting material.

26. An assembly comprising a solid-state structure (100, 200, 300, 400) as defined in any one of the preceding claims, a first contact layer (54) and a second contact layer (56) arranged at either side of the structure, and the semiconducting substrate is arranged outside one of the contact layers.

27. An assembly according to claim 26, wherein the contact layers comprise doped semiconducting material.

28. A pixel element comprising a structure as defined in any one of the claims 1 to 23.

29. A pixellated detector array comprising at least one pixel element as defined in claim 28.

30. A method of manufacturing a solid state structure (100, 200) for photodetection of radiation within a wavelength range, **characterized by**:
providing a semiconducting substrate (52), said substrate being non-absorbent to radiation within said wavelength range,
forming in a self-organizing manner a first set of quantum dots (16) of a first semiconducting material (SC1) on the substrate,
forming a semiconducting matrix layer (12) in between the quantum dots of the first set, such that the semiconducting matrix layer covers at least a lateral surface of the quantum dots,
forming in a self-organizing manner a second set of quantum dots (18) of a second; different, semiconducting material (SC2) such that the first set is arranged between said substrate and said second set, and such that a set of columns of aligned quantum dots is formed, wherein two consecutive quantum dots are quantum mechanically coupled,
forming a semiconducting matrix layer (12) in between the quantum dots of the second set, covering at least a lateral surface of the quantum dots,
repeating the formation of the first and second sets of quantum dots and the covering matrix layers, such that a set of quantum dot superlattice columns (14) in the matrix material is formed, and
wherein said step of forming a semiconducting matrix layer includes forming a semiconducting matrix layer of a material having a lattice constant essentially equal to that of the substrate, and wherein said matrix layer being essentially non-absorbent to radiation within said wavelength range.

31. The method according to claim 30, wherein the steps of forming the semiconducting matrix layer and the first and second set of quantum dots include
epitaxial forming of a semiconducting matrix layer and a first and second set of quantum dots.

32. The method according to claim 30 or 31, wherein the step of forming the semiconducting matrix layer includes
forming a semiconducting matrix layer of the same material as the substrate.

33. The method according to any one of the claims 30 to 32, wherein the steps of forming the first and second set of quantum dots include
forming a first and second set of quantum dots of a III-V material.

34. The method according to any one of the claims 30 to 33, wherein the step of forming the first set of quantum dots includes
forming a first set of quantum dots of an indium compound material.

35. The method according to any one of the claims 30 to 34, wherein the step of forming the first set of quantum dots includes
forming a first set of quantum dots of a material comprising indium and arsenide.

36. The method according to any one of the claims 30 to 35, wherein the step of forming the second set of quantum dots includes
forming a second set of quantum dots of an antimonide compound material.

37. The method according to any one of the claims 30 to 36, wherein the step of forming the second set of quantum dots includes
forming a second set of quantum dots of a material comprising gallium, indium and antimonide.

38. The method according to any one of the claims 30 to 37, wherein the step of forming the semiconducting matrix layer includes
forming a semiconducting matrix layer of a III-V material.

39. The method according to any one of the claims 30 to 38, wherein the step of forming the matrix material includes
forming a semiconducting matrix layer of GaAs.

40. The method according to any one of the claims 30 to 38, wherein the step of forming the matrix material includes
forming a semiconducting matrix layer of InP.

41. The method according to any one of the claims 30 to 37, wherein the step of forming the semiconducting matrix layer includes
forming a semiconducting matrix layer of a IV material.

42. The method according to any one of the claims 30 to 37, wherein the step of forming the semiconducting matrix layer includes
forming a semiconducting matrix layer of Si.

43. The method according to any one of the claims 30 to 42, wherein forming of the set of quantum dot superlattice columns in a matrix material includes
forming a first p-doped region (32) on the substrate,
forming a second doped or undoped region (34) on the first region, and
forming a third n-doped region (36) on the second region.

44. The method according to claim 43, wherein the step of forming a first p-doped region on the substrate includes
forming a first doped region of p-doped matrix layers, and wherein the step of forming a third n-doped region on the second region includes
forming a third doped region of n-doped matrix layers.

45. The method according to claims 43 or 44, wherein the step of forming a first p-doped region on the substrate further includes
forming a first doped region of a first set of p-doped quantum dots of a second semiconducting material, and wherein the step of forming a third n-doped region on the second region includes
forming a third doped region of a second set of n-doped quantum dots of a first semiconducting material.

46. The method according to any one of the claims 43 to 45, wherein the step of forming a second doped or undoped region includes
forming a second doped region of a first set of n- or p-doped quantum dots of a first or second semiconducting material, respectively, and/or n- or p-doped matrix layers.

47. The method according to any one of the claims 30 to 42, wherein the forming of the set of quantum dot superlattice columns in a matrix material includes
forming a first n-doped region on the substrate,
forming a second doped or undoped region on the first region, and
forming a third p-doped region on the second region.

48. The method according to claim 47, wherein the step of forming a first n-doped region on the substrate includes forming a first doped region of n-doped matrix layers, and
wherein the step of forming a third p-doped region on the second region includes forming a third doped region of p-doped matrix layers.

49. The method according to claim 47 or 48, wherein the step of forming a first n-doped region on the substrate further includes forming a first doped region of a first set of n-doped quantum dots of a first semiconducting material, and
wherein the step of forming a third p-doped region on the second region includes forming a third doped region of a second set of p-doped quantum dots of a second semiconducting material.

50. The method according to any one of the claims 47 to 49, wherein the step of forming a second doped or undoped region includes
forming a second doped region of a first set of n- or p-doped quantum dots of a first or second semiconducting material, respectively, and/or n- or p-doped matrix layers.

51. The method according to any one of claims 40 to 50, wherein the step of forming the semiconducting matrix layer includes
using a molecular beam epitaxy (MBE) process to deposit a semiconducting matrix layer.

52. The method according to any one of claims 40 to 50, wherein the step of forming the semiconducting matrix layer includes
using a metal-organic vapour-phase epitaxy (MOVPE) process, a chemical beam epitaxy process, or a metal-organic molecular beam epitaxy process to deposit a semiconducting matrix layer.

53. The method according to any one of claims 40 to 50, wherein the step of forming the first and second set of quantum dots of the first and second semiconducting material includes
using an electrochemical process to deposit a set of quantum dots.

54. The method according to any one of claims 30 to 53, further comprising the steps of:
providing a first contact layer (54) on the substrate prior to the step of forming the first set of quantum dots on the substrate, and
providing a second contact layer (56) over the set of quantum dot superlattice columns in the matrix material.

55. Use of a solid-state structure according to claim 1 for photovoltaic photodetection of radiation within a wavelength range of about 3 µm to about 12 µm, wherein the structure comprises an alternating series of quantum dots, in which each pair of two consecutive quantum dots comprises quantum dots, arranged of a first and second semiconducting material, respectively, and the first and second semiconducting material are each selected from the III-V materials.

56. Use of the solid-state structure according to claim 55, wherein the alternating series of quantum dots are combined with an embedding matrix material, for providing a monocrystalline solid-state structure.

## Patentansprüche

1. Festkörperstruktur (100, 200) zur Photodetektion von Strahlung innerhalb eines Wellenlängenbereichs, wobei Struktur von einem Halbleitersubstrat (52) getragen wird, wobei dieses Substrat im Wesentlichen keine Strahlung innerhalb des Wellenlängenbereichs absorbiert, und die Folgendes umfasst:
einen Satz parallel angeordneter, nivellierter Übergittersäulen (14), wobei jede Übergittersäule eine abwechselnde Reihe von Quantenpunkten (16, 18) umfasst, und
ein Matrixmaterial (12), das zwischen dem Satz Übergittersäulen angeordnet ist, wobei das Matrixmaterial ein Halbleitermaterial ist, das eine Gitterfehlanpassung relativ zu den Quantenpunkten in den Säulen aufweist, wobei das Matrixmaterial im Wesentlichen keine Strahlung innerhalb des Wellenlängenbereichs absorbiert, und
wobei die Gitterkonstante des Matrixmaterials im Wesentlichen gleich der Gitterkonstante des Substrats ist,
**dadurch gekennzeichnet, dass**, in einer Übergittersäule, jedes Paar zweier aufeinanderfolgender Quantenpunkte einen Quantenpunkt (16) eines ersten Halbleitermaterials (SC1) und einen Quantenpunkt (18) eines zweiten, anderen Halbleitermaterials (SC2) umfasst, die quantenmechanisch gekoppelt sind.

2. Struktur nach Anspruch 1, wobei der Wellenlängenbereich von etwa 3 µm bis etwa 12 µm reicht.

3. Struktur nach Anspruch 2, wobei der Wellenlängenbereich von etwa 3 µm bis etwa 5 µm reicht.

4. Struktur nach Anspruch 3, wobei, bis zu einer Betriebstemperatur von etwa 150 K, ein Verhältnis zwischen Photostrom und Dunkelstrom der Festkörperstruktur mindestens 10 beträgt.

5. Struktur nach Anspruch 2, wobei der Wellenlängenbereich von etwa 8 µm bis etwa 12 µm reicht.

6. Struktur nach Anspruch 5, wobei, bis zu einer Betriebstemperatur von etwa 100 K, ein Verhältnis zwischen Photostrom und Dunkelstrom der Festkörperstruktur mindestens 10 beträgt.

7. Struktur nach einem der vorangehenden Ansprüche, wobei die Festkörperstruktur monokristallin ist.

8. Struktur nach einem der vorangehenden Ansprüche, wobei das Matrixmaterial das gleiche Material wie das Substrat ist.

9. Struktur nach einem der vorangehenden Ansprüche, wobei die Quantenpunkte in den Übergittersäulen des Satzes in einer selbstjustierten Weise organisiert sind.

10. Struktur nach einem der vorangehenden Ansprüche, wobei die Quantenpunkte in mindestens einer Übergittersäule durch einen Abschnitt (22) des Matrixmaterials getrennt sind.

11. Struktur nach einem der vorangehenden Ansprüche, wobei das erste und das zweite Halbleitermaterial eine Energiezustandsausrichtung vom Typ II relativ zueinander aufweisen, dergestalt, dass Elektronen auf die Quantenpunkte des ersten Halbleitermaterials beschränkt sind und Löcher auf die Quantenpunkte des zweiten Halbleitermaterials beschränkt sind.

12. Struktur nach einem der vorangehenden Ansprüche, wobei das erste und das zweite Halbleitermaterial jeweils aus den III-V-Materialien ausgewählt sind.

13. Struktur nach einem der vorangehenden Ansprüche, wobei das erste Halbleitermaterial eine Indiumverbindung umfasst.

14. Struktur nach einem der vorangehenden Ansprüche, wobei das erste Halbleitermaterial Indium und Arsenid umfasst.

15. Struktur nach einem der vorangehenden Ansprüche, wobei das zweite Halbleitermaterial eine Antimonidverbindung umfasst.

16. Struktur nach einem der vorangehenden Ansprüche, wobei das zweite Halbleitermaterial Gallium, Indium und Antimonid umfasst.

17. Struktur nach einem der vorangehenden Ansprüche, wobei das Matrixmaterial aus den III-V-Materialien ausgewählt ist.

18. Struktur nach Anspruch 17, wobei das Matrixmaterial GaAs umfasst.

19. Struktur nach Anspruch 17, wobei das Matrixmaterial InP umfasst.

20. Struktur nach einem der Ansprüche 1 bis 16, wobei das Matrixmaterial aus IV-Materialien ausgewählt ist.

21. Struktur nach Anspruch 20, wobei das Matrixmaterial Si umfasst.

22. Struktur nach einem der vorangehenden Ansprüche, wobei Struktur (300) eine erste, p-dotierte, Region (32), eine zweite, undotierte, Region (34) und eine dritte, n-dotierte, Region (36) in einer Richtung parallel zu den Säulen umfasst, wobei die zweite Region zwischen der ersten und der dritten Region angeordnet ist.

23. Struktur nach Anspruch 22, wobei das Matrixmaterial (37, 39) der ersten und der dritten Region dotiert ist.

24. Struktur nach Anspruch 22 oder 23, wobei die Quantenpunkte des ersten Halbleitermaterials in der ersten Region dotiert sind und die Quantenpunkte des zweiten Halbleitermaterials in der dritten Region dotiert sind.

25. Struktur (300, 400) nach einem der Ansprüche 22 bis 24, wobei die zweite Region (34) dotiertes Matrixmaterial (38) und/oder dotierte Quantenpunkte (45, 46) aus dem ersten oder zweiten Halbleitermaterial umfasst.

26. Baugruppe, die eine Festkörperstruktur (100, 200, 300, 400) nach einem der vorangehenden Ansprüche umfasst, wobei eine erste Kontaktschicht (54) und eine zweite Kontaktschicht (56) auf der einen bzw. auf der anderen Seite der Struktur angeordnet sind und das Halbleitersubstrat außerhalb einer der Kontaktschichten angeordnet ist.

27. Baugruppe nach Anspruch 26, wobei die Kontaktschichten dotiertes Halbleitermaterial umfassen.

28. Bildelement, das eine Struktur nach einem der Ansprüche 1 bis 23 umfasst.

29. Aus Bildelementen aufgebaute Detektorgruppierung, die mindestens ein Bildelement nach Anspruch 28 umfasst.

30. Verfahren zur Herstellung einer Festkörperstruktur (100, 200) zur Photodetektion von Strahlung innerhalb eines Wellenlängenbereichs, **gekennzeichnet durch**:
Bereitstellen eines Halbleitersubstrats (52), wobei dieses Substrat keine Strahlung innerhalb des Wellenlängenbereichs absorbiert,
Ausbilden - in einer selbstorganisierenden Weise - eines ersten Satzes Quantenpunkte (16) aus einem ersten Halbleitermaterial (SC1) auf dem Substrat,
Ausbilden einer Halbleitermatrixschicht (12) zwischen den Quantenpunkten des ersten Satzes, dergestalt, dass die Halbleitermatrixschicht mindestens eine Mantelfläche der Quantenpunkte bedeckt,
Ausbilden, in einer selbstorganisierenden Weise, eines zweiten Satzes Quantenpunkte (18) aus einem zweiten, anderen Halbleitermaterial (SC2), dergestalt, dass der erste Satz zwischen dem Substrat und dem zweiten Satzes angeordnet ist, und dergestalt, dass ein Satz Säulen aus ausgerichteten Quantenpunkten gebildet wird, wobei zwei aufeinanderfolgende Quantenpunkte quantenmechanisch gekoppelt sind,
Ausbilden einer Halbleitermatrixschicht (12) zwischen den Quantenpunkten des zweiten Satzes, die mindestens eine Mantelfläche der Quantenpunkte bedeckt,
Wiederholen des Ausbildens des ersten und des zweiten Satzes Quantenpunkte und der bedeckenden Matrixschichten, dergestalt, dass ein Satz Quantenpunkt-Übergittersäulen (14) in dem Matrixmaterial gebildet wird, und
wobei der Schritt des Ausbildens einer Halbleitermatrixschicht das Ausbilden einer Halbleitermatrixschicht aus einem Material umfasst, dessen Gitterkonstante im Wesentlichen gleich der Gitterkonstante des Substrats ist und wobei die Matrixschicht im Wesentlichen keine Strahlung innerhalb des Wellenlängenbereichs absorbiert.

31. Verfahren nach Anspruch 30, wobei der Schritt des Ausbildens der Halbleitermatrixschicht und des ersten und des zweiten Satzes Quantenpunkte Folgendes enthält:
epitaxiales Ausbilden einer Halbleitermatrixschicht und eines ersten und eines zweiten Satzes Quantenpunkte.

32. Verfahren nach Anspruch 30 oder 31, wobei der Schritt des Ausbildens der Halbleitermatrixschicht Folgendes enthält:
Ausbilden einer Halbleitermatrixschicht aus dem gleichen Material wie das Substrat.

33. Verfahren nach einem der Ansprüche 30 bis 32, wobei der Schritt des Ausbildens des ersten und des zweiten Satzes Quantenpunkte Folgendes enthält:
Ausbilden eines ersten und eines zweiten Satzes Quantenpunkte aus einem III-V-Material.

34. Verfahren nach einem der Ansprüche 30 bis 33, wobei der Schritt des Ausbildens des ersten Satzes Quantenpunkte Folgendes enthält:
Ausbilden eines ersten Satzes Quantenpunkte aus einem Material aus einer Indiumverbindung.

35. Verfahren nach einem der Ansprüche 30 bis 34, wobei der Schritt des Ausbildens des ersten Satzes Quantenpunkte Folgendes enthält:
Ausbilden eines ersten Satzes Quantenpunkte aus einem Material, das Indium und Arsenid umfasst.

36. Verfahren nach einem der Ansprüche 30 bis 35, wobei der Schritt des Ausbildens des zweiten Satzes Quantenpunkte Folgendes enthält:
Ausbilden eines zweiten Satzes Quantenpunkte aus einem Material aus einer Antimonidverbindung.

37. Verfahren nach einem der Ansprüche 30 bis 36, wobei der Schritt des Ausbildens des zweiten Satzes Quantenpunkte Folgendes enthält:
Ausbilden eines zweiten Satzes Quantenpunkte aus einem Material, das Gallium, Indium und Antimonid umfasst.

38. Verfahren nach einem der Ansprüche 30 bis 37, wobei der Schritt des Ausbildens der Halbleitermatrixschicht Folgendes enthält:
Ausbilden einer Halbleitermatrixschicht aus einem III-V-Material.

39. Verfahren nach einem der Ansprüche 30 bis 38, wobei der Schritt des Ausbildens des Matrixmaterials Folgendes enthält:
Ausbilden einer Halbleitermatrixschicht aus GaAs.

40. Verfahren nach einem der Ansprüche 30 bis 38, wobei der Schritt des Ausbildens des Matrixmaterials Folgendes enthält:
Ausbilden einer Halbleitermatrixschicht aus InP.

41. Verfahren nach einem der Ansprüche 30 bis 37, wobei der Schritt des Ausbildens der Halbleitermatrixschicht Folgendes enthält:
Ausbilden einer Halbleitermatrixschicht aus einem IV-Material.

42. Verfahren nach einem der Ansprüche 30 bis 37, wobei der Schritt des Ausbildens der Halbleitermatrixschicht Folgendes enthält:
Ausbilden einer Halbleitermatrixschicht aus Si.

43. Verfahren nach einem der Ansprüche 30 bis 42, wobei Ausbilden des Satzes Quantenpunkt-Übergittersäulen in einem Matrixmaterial Folgendes enthält:
Ausbilden einer ersten, p-dotierten, Region (32) auf dem Substrat,
Ausbilden einer zweiten, dotierten oder undotierte, Region (34) auf der ersten Region, und
Ausbilden einer dritten, n-dotierten, Region (36) auf der zweiten Region.

44. Verfahren nach Anspruch 43, wobei der Schritt des Ausbildens einer ersten, p-dotierten, Region auf dem Substrat Folgendes enthält:
Ausbilden einer ersten, dotierten, Region aus p-dotierten Matrixschichten, und wobei der Schritt des Ausbildens einer dritten, n-dotierten, Region auf der zweiten Region Folgendes enthält:
Ausbilden einer dritten, dotierten, Region aus n-dotierten Matrixschichten.

45. Verfahren nach Anspruch 43 oder 44, wobei der Schritt des Ausbildens einer ersten, p-dotierten, Region auf dem Substrat des Weiteren Folgendes enthält:
Ausbilden einer ersten, dotierten, Region aus einem ersten Satz p-dotierter Quantenpunkte aus einem zweiten Halbleitermaterial, und wobei der Schritt des Ausbildens einer dritten, n-dotierten, Region auf der zweiten Region Folgendes enthält:
Ausbilden einer dritten, dotierten, Region aus einem zweiten Satz n-dotierter Quantenpunkte aus einem ersten Halbleitermaterial.

46. Verfahren nach einem der Ansprüche 43 bis 45, wobei der Schritt des Ausbildens einer zweiten, dotierten oder undotierten, Region Folgendes enthält:
Ausbilden einer zweiten, dotierten, Region aus einem ersten Satz n- oder p-dotierter Quantenpunkte aus einem ersten oder zweiten Halbleitermaterial und/oder n- oder p-dotierten Matrixschichten.

47. Verfahren nach einem der Ansprüche 30 bis 42, wobei das Ausbilden des Satzes Quantenpunkt-Übergittersäulen in einem Matrixmaterial Folgendes enthält:
Ausbilden einer ersten, n-dotierten, Region auf dem Substrat,
Ausbilden einer zweiten, dotierten oder undotierten, Region auf der ersten Region, und
Ausbilden einer dritten, p-dotierten, Region auf der zweiten Region.

48. Verfahren nach Anspruch 47, wobei der Schritt des Ausbildens einer ersten, n-dotierten, Region auf dem Substrat Folgendes enthält:
Ausbilden einer ersten, dotierten, Region aus n-dotierten Matrixschichten, und
wobei der Schritt des Ausbildens einer dritten, p-dotierten, Region auf der zweiten Region Folgendes enthält:
Ausbilden einer dritten, dotierten, Region aus p-dotierten Matrixschichten.

49. Verfahren nach Anspruch 47 oder 48, wobei der Schritt des Ausbildens einer ersten, n-dotierten, Region auf dem Substrat des Weiteren Folgendes enthält:
Ausbilden einer ersten, dotierten, Region aus einem ersten Satz n-dotierter Quantenpunkte aus einem ersten Halbleitermaterial, und
wobei der Schritt des Ausbildens einer dritten, p-dotierten, Region auf der zweiten Region Folgendes enthält:
Ausbilden einer dritten, dotierten, Region aus einem zweiten Satz p-dotierter Quantenpunkte aus einem zweiten Halbleitermaterial.

50. Verfahren nach einem der Ansprüche 47 bis 49, wobei der Schritt des Ausbildens einer zweiten, dotierten oder undotierten, Region Folgendes enthält:
Ausbilden einer zweiten, dotierten, Region aus einem ersten Satz n- oder p-dotierter Quantenpunkte aus einem ersten oder zweiten Halbleitermaterial und/oder n- oder p-dotierten Matrixschichten.

51. Verfahren nach einem der Ansprüche 40 bis 50, wobei der Schritt des Ausbildens der Halbleitermatrixschicht Folgendes enthält:
Anwenden eines Molekularstrahlepitaxie (MBE)-Prozesses zum Abscheiden einer Halbleitermatrixschicht.

52. Verfahren nach einem der Ansprüche 40 bis 50, wobei der Schritt des Ausbildens der Halbleitermatrixschicht Folgendes enthält:
Anwenden eines metallorganischen Dampfphasenepitaxie (MOVPE)-Prozesses, eines chemischen Strahlepitaxieprozesses oder eines metallorganischen Molekularstrahlepitaxieprozesses zum Abscheiden einer Halbleitermatrixschicht.

53. Verfahren nach einem der Ansprüche 40 bis 50, wobei der Schritt des Ausbildens des ersten und des zweiten Satzes Quantenpunkte aus dem ersten und dem zweiten Halbleitermaterial Folgendes enthält:
Anwenden eines elektrochemischen Prozesses zum Abscheiden eines Satzes Quantenpunkte.

54. Verfahren nach einem der Ansprüche 30 bis 53, das des Weiteren Folgende Schritte umfasst:
Ausbilden einer ersten Kontaktschicht (54) auf dem Substrat vor dem Schritt des Ausbildens des ersten Satzes Quantenpunkte auf dem Substrat, und
Ausbilden einer zweiten Kontaktschicht (56) über dem Satz Quantenpunkt-Übergittersäulen in dem Matrixmaterial.

55. Verwenden einer Festkörperstruktur nach Anspruch 1 zur photovoltaischen Photodetektion von Strahlung innerhalb eines Wellenlängenbereichs von etwa 3 µm bis etwa 12 µm, wobei die Struktur eine abwechselnde Reihe von Quantenpunkten umfasst, wobei jedes Paar zweier aufeinanderfolgender Quantenpunkte Quantenpunkte umfasst, die aus einem ersten bzw. zweiten Halbleitermaterial bestehen, und das erste und das zweite Halbleitermaterial jeweils aus den III-V-Materialien ausgewählt sind.

56. Verwenden der Festkörperstruktur nach Anspruch 55, wobei die abwechselnde Reihe von Quantenpunkten mit einem einbettenden Matrixmaterial kombiniert ist, um eine monokristalline Festkörperstruktur bereitzustellen.

## Revendications

1. Structure d'état solide (100, 200) pour la photodétection de rayonnement dans une plage de longueurs d'onde, ladite structure étant portée par un substrat semi-conducteur (52), lequel substrat est sensiblement non absorbant du rayonnement dans ladite plage de longueur d'onde, comprenant :
un ensemble de colonnes de super-réseau nivelées (14) agencées en parallèle, où chaque colonne de super-réseau comprend une série en alternance de points quantiques (16, 18) ; et
un matériau de matrice (12) agencé entre ledit ensemble de colonnes de super-réseau, le matériau de matrice étant un matériau semi-conducteur ayant un décalage de réseau par rapport aux points quantiques dans les colonnes, lequel matériau de matrice est sensiblement non absorbant du rayonnement dans ladite plage de longueurs d'onde, et
dans laquelle la constante de réseau dudit matériau de matrice est sensiblement égale à la constante de réseau dudit substrat,
**caractérisée en ce que**, dans une colonne de super-réseau, chaque paire de deux points quantiques consécutifs comprend un point quantique (16) d'un premier matériau semi-conducteur (SC1) et un point quantique (18) d'un second matériau semi-conducteur différent (SC2) ayant un couplage mécanique quantique.

2. Structure selon la revendication 1, dans laquelle la plage de longueurs d'onde est d'environ 3 µm à environ 12 µm.

3. Structure selon la revendication 2, dans laquelle la plage de longueurs d'onde est d'environ 3 µm à environ 5 µm.

4. Structure selon la revendication 3, dans laquelle, jusqu'à une température de fonctionnement d'environ 150 K, un rapport entre le photo-courant et le courant d'obscurité de la structure d'état solide est d'au moins 10.

5. Structure selon la revendication 2, dans laquelle la plage de longueurs d'onde est d'environ 8 µm à environ 12 µm.

6. Structure selon la revendication 5, dans laquelle, jusqu'à une température de fonctionnement d'environ 100 K, un rapport entre le photo-courant et le courant d'obscurité de la structure d'état solide est d'au moins 10.

7. Structure selon l'une quelconque des revendications précédentes, dans laquelle la structure d'état solide est monocristalline.

8. Structure selon l'une quelconque des revendications précédentes, dans laquelle le matériau de matrice est le même que celui du substrat.

9. Structure selon l'une quelconque des revendications précédentes, dans laquelle les points quantiques dans les colonnes de super-réseau de l'ensemble sont organisés d'une manière auto-alignée.

10. Structure selon l'une quelconque des revendications précédentes, dans laquelle les points quantiques dans au moins une colonne de super-réseau sont séparés par une partie (22) du matériau de matrice.

11. Structure selon l'une quelconque des revendications précédentes, dans laquelle lesdits premier et second matériaux semi-conducteurs présentent respectivement un alignement de niveau d'énergie de type II l'un par rapport à l'autre, de sorte que les électrons sont confinés dans les points quantiques du premier matériau semi-conducteur et les trous sont confinés dans les points quantiques du second matériau semi-conducteur.

12. Structure selon l'une quelconque des revendications précédentes, dans laquelle les premier et second matériaux semi-conducteurs sont chacun sélectionnés parmi les matériaux III-V.

13. Structure selon l'une quelconque des revendications précédentes, dans laquelle le premier matériau semi-conducteur comprend un composé d'indium.

14. Structure selon l'une quelconque des revendications précédentes, dans laquelle le premier matériau semi-conducteur comprend de l'indium et de l'arséniure.

15. Structure selon l'une quelconque des revendications précédentes, dans laquelle le second matériau semi-conducteur comprend un composé d'antimoine.

16. Structure selon l'une quelconque des revendications précédentes, dans laquelle le second matériau semi-conducteur comprend du gallium, de l'indium et de l'antimoine.

17. Structure selon l'une quelconque des revendications précédentes, dans laquelle le matériau de matrice est sélectionné parmi les matériaux III-V.

18. Structure selon la revendication 17, dans laquelle le matériau de matrice comprend du GaAs.

19. Structure selon la revendication 17, dans laquelle le matériau de matrice comprend de l'InP.

20. Structure selon l'une quelconque des revendications 1 à 16, dans laquelle le matériau de matrice est sélectionné parmi les matériaux IV.

21. Structure selon la revendication 20, dans laquelle le matériau de matrice comprend du Si.

22. Structure selon l'une quelconque des revendications précédentes, dans laquelle la structure (300) comprend une première région dopée en p (32), une deuxième région non dopée (34) et une troisième région dopée en n (36) dans une direction parallèle aux colonnes, dans laquelle la deuxième région est agencée entre la première région et la troisième région.

23. Structure selon la revendication 22, dans laquelle le matériau de matrice (37, 39) de la première région et de la troisième région est dopé.

24. Structure selon la revendication 22 ou 23, dans laquelle les points quantiques du premier matériau semi-conducteur dans la première région sont dopés et les points quantiques du deuxième matériau semi-conducteur dans la troisième région sont dopés.

25. Structure (300, 400) selon l'une quelconque des revendications 22 à 24, dans laquelle la deuxième région (34) comprend un matériau de matrice dopé (38) et/ou des points quantiques dopés (45, 46) du premier ou second matériau semi-conducteur.

26. Assemblage comprenant une structure d'état solide (100, 200, 300, 400) selon l'une quelconque des revendications précédentes, une première couche de contact (54) et une seconde couche de contact (56) agencées des deux côtés de la structure, et le substrat semi-conducteur est agencé à l'extérieur de l'une des couches de contact.

27. Assemblage selon la revendication 26, dans lequel les couches de contact comprennent un matériau semi-conducteur dopé.

28. Elément de pixel comprenant une structure selon l'une quelconque des revendications 1 à 23.

29. Matrice de détecteurs à conversion en pixels comprenant au moins un élément de pixel selon la revendication 28.

30. Procédé de fabrication d'une structure d'état solide (100, 200) pour la photodétection de rayonnement dans une plage de longueurs d'onde, **caractérisé par**
la fourniture d'un substrat semi-conducteur (52), ledit substrat étant non absorbant au rayonnement dans ladite plage de longueurs d'onde,
la formation d'une manière auto-organisée d'un premier ensemble de points quantiques (16) d'un premier matériau semi-conducteur (SC1) sur le substrat,
la formation d'une couche de matrice semi-conductrice (12) entre les points quantiques du premier ensemble, de sorte que la couche de matrice semi-conductrice couvre au moins une surface latérale des points quantiques,
la formation d'une manière auto-organisée d'un deuxième ensemble de points quantiques (18) d'un second matériau semi-conducteur différent (SC2) de sorte que le premier ensemble est agencé entre ledit substrat et ledit second ensemble, et de sorte qu'un ensemble de colonnes de points quantiques alignés est formé, dans lequel deux points quantiques consécutifs sont couplés par couplage mécanique quantique,
la formation d'une couche de matrice semi-conductrice (12) entre les points quantiques du second ensemble, couvrant au moins une surface latérale des points quantiques,
la répétition de la formation des premier et second ensembles de points quantiques et des couches de matrice de recouvrement, de sorte qu'un ensemble de colonnes de super-réseau de points quantiques (14) dans le matériau de matrice est formé, et
dans lequel ladite étape de formation d'une couche de matrice semi-conductrice comprend la formation d'une couche de matrice semi-conductrice d'un matériau ayant une constante de réseau sensiblement égale à celle du substrat, et dans lequel ladite couche de matrice est sensiblement non absorbante au rayonnement dans ladite plage de longueurs d'onde.

31. Procédé selon la revendication 30, dans lequel les étapes de formation de la couche de matrice semi-conductrice et des premier et second ensembles de points quantiques comprennent :
la formation épitaxiale d'une couche de matrice semi-conductrice et
des premier et second ensembles de points quantiques.

32. Procédé selon la revendication 30 ou 31, dans lequel l'étape de formation de la couche de matrice semi-conductrice comprend :
la formation d'une couche de matrice semi-conductrice du même matériau que celui du substrat.

33. Procédé selon l'une quelconque des revendications 30 à 32, dans lequel les étapes de formation des premier et second ensembles de points quantiques comprennent :
la formation des premier et second ensembles de points quantiques d'un matériau III-V.

34. Procédé selon l'une quelconque des revendications 30 à 33, dans lequel l'étape de formation du premier ensemble de points quantiques comprend :
la formation d'un premier ensemble de points quantiques d'un matériau de composé d'indium.

35. Procédé selon l'une quelconque des revendications 30 à 34, dans lequel l'étape de formation du premier ensemble de points quantiques comprend :
la formation d'un premier ensemble de points quantiques d'un matériau comprenant de l'indium et de l'arséniure.

36. Procédé selon l'une quelconque des revendications 30 à 35, dans lequel l'étape de formation du second ensemble de points quantiques comprend :
la formation d'un second ensemble de points quantiques d'un matériau de composé d'antimoine.

37. Procédé selon l'une quelconque des revendications 30 à 36, dans lequel l'étape de formation du second ensemble de points quantiques comprend :
la formation d'un second ensemble de points quantiques d'un matériau comprenant du gallium, de l'indium et de l'antimoine.

38. Procédé selon l'une quelconque des revendications 30 à 37, dans lequel l'étape de formation de la couche de matrice semi-conductrice comprend :
la formation d'une couche de matrice semi-conductrice d'un matériau III-V.

39. Procédé selon l'une quelconque des revendications 30 à 38, dans lequel l'étape de formation du matériau de matrice comprend :
la formation d'une couche de matrice semi-conductrice de GaAs.

40. Procédé selon l'une quelconque des revendications 30 à 38, dans lequel l'étape de formation du matériau de matrice comprend :
la formation d'une couche de matrice semi-conductrice d'InP.

41. Procédé selon l'une quelconque des revendications 30 à 37, dans lequel l'étape de formation de la couche de matrice semi-conductrice comprend :
la formation d'une couche de matrice semi-conductrice d'un matériau IV.

42. Procédé selon l'une quelconque des revendications 30 à 37, dans lequel l'étape de formation de la couche de matrice semi-conductrice comprend :
la formation d'une couche de matrice semi-conductrice de Si.

43. Procédé selon l'une quelconque des revendications 30 à 42, dans lequel la formation de l'ensemble de colonnes de super-réseau de points quantiques dans un matériau de matrice comprend :
la formation d'une première région dopée en p (32) sur le substrat,
la formation d'une deuxième région dopée ou non dopée (34) sur la première région, et
la formation d'une troisième région dopée en n (36) sur la deuxième région.

44. Procédé selon la revendication 43, dans lequel l'étape de formation d'une première région dopée en p sur le substrat comprend :
la formation d'une première région dopée de couches de matrice dopées en p, et dans lequel l'étape de formation d'une troisième région dopée en n sur la deuxième région comprend :
la formation d'une troisième région dopée de couches de matrice dopées en n.

45. Procédé selon la revendication 43 ou 44, dans lequel l'étape de formation d'une première région dopée en p sur le substrat comprend en outre :
la formation d'une première région dopée d'un premier ensemble de points quantiques dopés en p d'un second matériau semi-conducteur, et dans lequel l'étape de formation d'une troisième région dopée en n sur la deuxième région comprend :
la formation d'une troisième région dopée d'un second ensemble de points quantiques dopés en n d'un premier matériau semi-conducteur.

46. Procédé selon l'une quelconque des revendications 43 à 45, dans lequel l'étape de formation d'une deuxième région dopée ou non dopée comprend :
la formation d'une deuxième région dopée d'un premier ensemble de points quantiques dopés en n ou en p d'un premier ou second matériau semi-conducteur respectivement, et/ou de couches de matrice dopées en n ou en p.

47. Procédé selon l'une quelconque des revendications 30 à 42, dans lequel la formation de l'ensemble de colonnes de super-réseau de points quantiques dans un matériau de matrice comprend :
la formation d'une première région dopée en n sur le substrat,
la formation d'une deuxième région dopée ou non dopée sur la première région, et
la formation d'une troisième région dopée en p sur la deuxième région.

48. Procédé selon la revendication 47, dans lequel l'étape de formation d'une première région dopée en p sur le substrat comprend la formation d'une première région dopée de couches de matrice dopées en n, et
dans lequel l'étape de formation d'une troisième région dopée en p sur la deuxième région comprend la formation d'une troisième région dopée de couches de matrice dopées en p.

49. Procédé selon la revendication 47 ou 48, dans lequel l'étape de formation d'une première région dopée en n sur le substrat comprend en outre la formation d'une première région dopée d'un premier ensemble de points quantiques dopés en n d'un premier matériau semi-conducteur, et
dans lequel l'étape de formation d'une troisième région dopée en p sur la deuxième région comprend la formation d'une troisième région dopée d'un second ensemble de points quantiques dopés en p d'un second matériau semi-conducteur.

50. Procédé selon l'une quelconque des revendications 47 à 49, dans lequel l'étape de formation d'une deuxième région dopée ou non dopée comprend :
la formation d'une deuxième région dopée d'un premier ensemble de points quantiques dopés en n ou en p d'un premier ou second matériau semi-conducteur respectivement, et/ou de couches de matrice dopées en n ou en p.

51. Procédé selon l'une quelconque des revendications 40 à 50, dans lequel l'étape de formation de la couche de matrice semi-conductrice comprend :
l'utilisation d'un processus d'épitaxie par jets moléculaires (MBE) pour déposer une couche de matrice semi-conductrice.

52. Procédé selon l'une quelconque des revendications 40 à 50, dans lequel l'étape de formation de la couche de matrice semi-conductrice comprend :
l'utilisation d'un processus d'épitaxie en phase vapeur de mélanges organométalliques (MOVPE), un processus d'épitaxie par jets moléculaires ou un processus d'épitaxie par jets moléculaires organométalliques pour déposer une couche de matrice semi-conductrice.

53. Procédé selon l'une quelconque des revendications 40 à 50, dans lequel l'étape de formation des premier et second ensembles de points quantiques des premier et second matériaux semi-conducteurs comprend :
l'utilisation d'un processus électrochimique pour déposer un ensemble de points quantiques.

54. Procédé selon l'une quelconque des revendications 30 à 53, comprenant en outre les étapes de :
la fourniture d'une première couche de contact (54) sur le substrat avant l'étape de formation du premier ensemble de points quantiques sur le substrat, et
la fourniture d'une seconde couche de contact (56) sur l'ensemble de colonnes de super-réseau de points quantiques dans le matériau de matrice.

55. Utilisation d'une structure d'état solide selon la revendication 1 pour la photodétection photovoltaïque de rayonnement dans une plage de longueurs d'onde d'environ 3 µm à environ 12 µm, dans laquelle la structure comprend une série en alternance de points quantiques, dans laquelle chaque paire de deux points quantiques consécutifs comprend des points quantiques agencés d'un premier matériau semi-conducteur et d'un second matériau semi-conducteur respectivement, et les premier et second matériaux semi-conducteurs sont chacun sélectionnés parmi les matériaux III-V.

56. Utilisation de la structure d'état solide selon la revendication 55, dans laquelle la série en alternance de points quantiques est combinée avec un matériau de matrice d'intégration pour fournir une structure d'état solide monocristalline.
